Europäisches Patentamt

European Patent Office

Office européen des brevets

(19)

(11) Veröffentlichungsnummer: **0 024 732**
A2

(12) # EUROPÄISCHE PATENTANMELDUNG

(21) Anmeldenummer: **80105133.5**

(22) Anmeldetag: **28.08.80**

(51) Int. Cl.³: **H 01 L 27/10**
**H 01 L 21/82, G 11 C 11/34**

(30) Priorität: **31.08.79 DE 2935254**
**31.08.79 DE 2935291**

(43) Veröffentlichungstag der Anmeldung:
**11.03.81 Patentblatt 81/10**

(84) Benannte Vertragsstaaten:
**FR GB NL**

(71) Anmelder: **SIEMENS AKTIENGESELLSCHAFT Berlin und München**
**Postfach 22 02 61**
**D-8000 München 22(DE)**

(72) Erfinder: **Wieder, Armin, Dr.**
**Wiesmahdstrasse 9**
**D-8035 Gauting(DE)**

(54) **Monolithische statische Speicherzelle, Verfahren zu ihrer Herstellung und Verfahren zu ihrem Betrieb.**

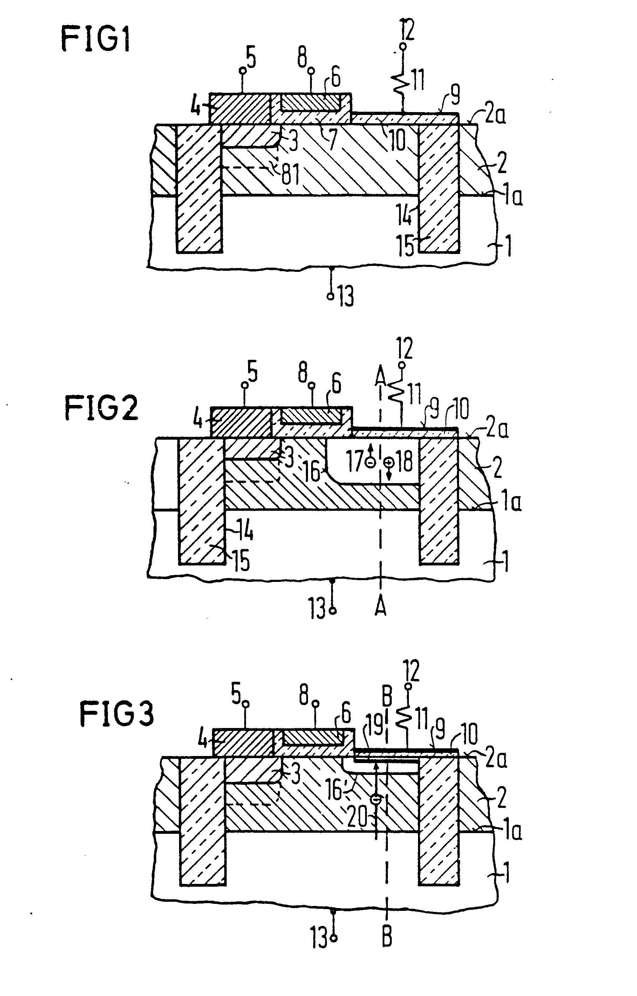

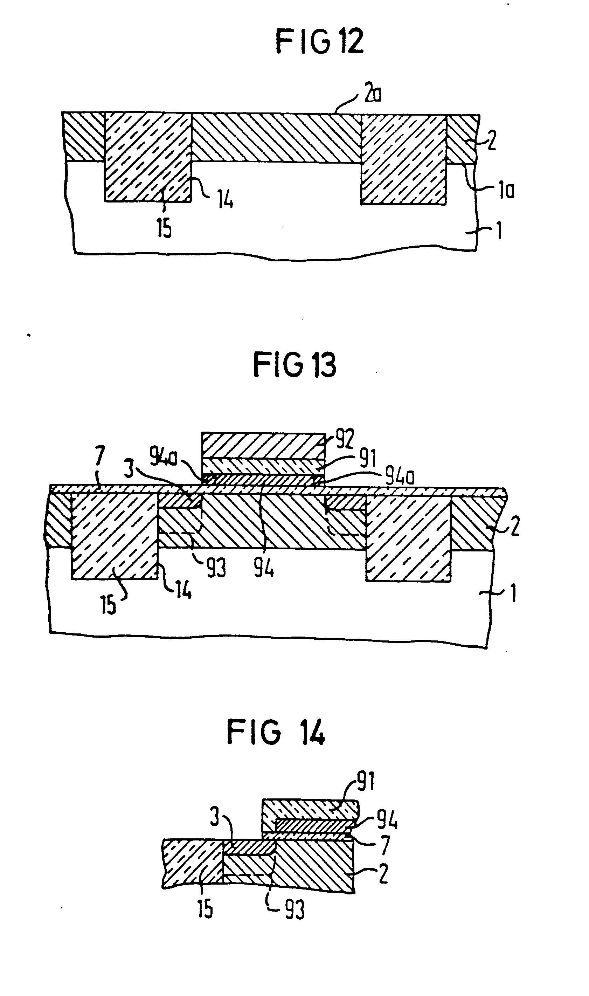

(57) Die Erfindung betrifft eine monolithische statische Speicherzelle, bei der die eingelesene digitale Signale ohne Regenerierungsvorgänge gespeichert werden können, Verfahren zu ihrer Herstellung und Verfahren zu ihrem Betrieb. Angestrebt wird die Realisierung einer solchen Zelle auf einer möglichst kleinen Halbleiterfläche. Zu diesem Zweck werden ein MIS-Transferelement und ein bistabiles Schaltelement nebeneinander an der Grenzfläche einer Halbleiterschicht plaziert, die auf einem Halbleiterkörper entgegengesetzter Leitfähigkeit angeordnet ist. Durch eine über das Transferelement eingelesene Inversionsladung wird das bistabile Element von einem kleinen Generationsstrom auf einen großen Injektionsstrom umgeschaltet. Vorteilhaft ist der kleine Flächenbedarf, der dem einer dynamischen Ein-Transistor-Zelle entspricht (Fig. 1). Das Herstellverfahren erfolgt in einer Drei-Lagen- Polysilizium-Technologie, bei dem selektive, vertikal ausgerichtete, reaktive Plasma-Ätzschritte wiederholt auftreten. Das Verfahren zeichnet sich dadurch besonders aus, daß sämtliche Verfahrensschritte selbstjustierend sind (Fig. 12).
Der Anwendungsbereich der auf diese Weise hergestellten Speicherzelle umfaßt höchstintegrierte Logik- und Speicherbausteine.

EP 0 024 732 A2

FIG1

FIG 12

SIEMENS AKTIENGESELLSCHAFT      Unser Zeichen
Berlin und München              VPA 79 P 7131 EUR

Monolithische statische Speicherzelle, Verfahren zu
ihrer Herstellung und Verfahren zu ihrem Betrieb.

Die Erfindung bezieht sich auf eine monolithische statische Speicherzelle nach dem Oberbegriff des Anspruchs 1, und auf Verfahren zu ihrer Herstellung und zu ihrem Betrieb.

Es sind statische RAM-Speicherzellen bekannt, die aus einer Mehrzahl von in MIS-Technik (Metall-Isolierschicht-Halbleiter-Technik) aufgebauten, auf einem Halbleiterkörper integrierten Feldeffekttransistoren bestehen. Hierzu sei auf das Buch "Semiconductor Memory Design and Application" von Luecke, Mize und Carr, McGraw-Hill Kogakusha Ltd., Tokyo, Seiten 117-119 hingewiesen. Für die Realisierung einer solchen Speicherzelle muß ein der Anzahl der Feldeffekttransistoren entsprechender Teil einer Grenzfläche des Halbleiterkörpers zur Verfügung gestellt werden. Andererseits sind auf einem Halbleiterkörper integrierte, dynamische Ein-Transistor-Speicherzellen bekannt (vgl. IEEE Journal of Solid State Circuits, Vol. SC-7, No.5, Oktober 1972, Seiten 336-340), die einen wesentlich kleineren Teil seiner Grenzfläche beanspruchen, jedoch so betrieben werden müssen, daß die in ihnen gespeicherten digitalen Informationen periodisch ausgelesen, regeneriert und wieder eingelesen werden. Auch bei der Auslesung der gespeicherten Informationen ist eine Regenerierung derselben erforderlich.

Der Erfindung liegt die Aufgabe zugrunde, eine statische Speicherzelle vorzusehen, die auf einer wesentlich kleineren Halbleiterfläche realisiert werden kann als die herkömmlichen statischen Speicherzellen. Diese Aufgabe wird durch die im Anspruch 1 gekennzeichneten Merkmale gelöst.

Die statische Speicherzelle nach der Erfindung zeichnet sich insbesondere dadurch aus, daß sie einen mit einer dynamischen Ein-Transistor-Speicherzelle vergleichbaren, geringen Bedarf an Halbleiterfläche hat, ohne daß die bei dynamischen Speicherzellen auftretenden, bereits erwähnten Nachteile der periodischen Regenerierung der gespeicherten digitalen Informationen auftreten. Daher erlaubt die erfindungsgemäße statische Speicherzelle bei der Verwendung in Halbleiterspeichern eine Erhöhung der Bitdichte auf sonst nur mit dynamisch betriebenen Speicherzellen erreichbare Werte, ohne daß der bei den letzteren notwendige Schaltungsmehraufwand für eine Regenerierung und Taktung getragen werden muß.

Die Unteransprüche sind auf bevorzugte Weiterbildungen und Ausgestaltungen der Erfindung sowie auf Verfahren zur Herstellung und zum Betrieb einer Speicherzelle nach der Erfindung gerichtet.

Die Erfindung wird nachfolgend anhand der Zeichnung näher erläutert. Dabei zeigt:

Fig.1 eine Prinzipdarstellung einer nach der Erfindung

0024732

ausgebildeten Speicherzelle,

Fig.2   die schematische Darstellung eines ersten Betriebszustandes der Speicherzelle nach Fig.1,

Fig.3   die schematische Darstellung eines zweiten Betriebszustandes dieser Speicherzelle,

Fig.4   die Darstellung eines zu Fig.2 und Fig.5 gehörenden Potentialverlaufs,

Fig.5   eine schematische Darstellung des Zellenquerschnittes, in dem der Potentialverlauf nach Fig.4
und Fig.6 auftritt,

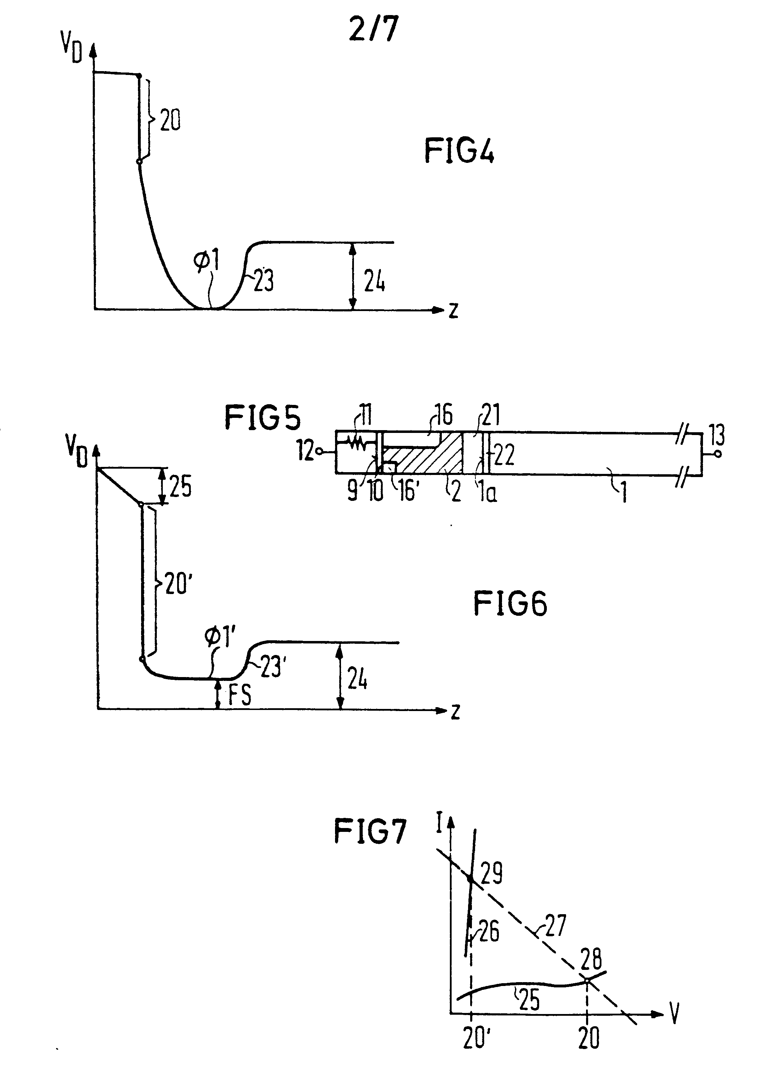

Fig.6   die Darstellung eines zu den Fig.3 und 5 gehörenden Potentialverlaufes,

Fig.7   ein Funktionsdiagramm zu einer Teilschaltung von
Fig.1,

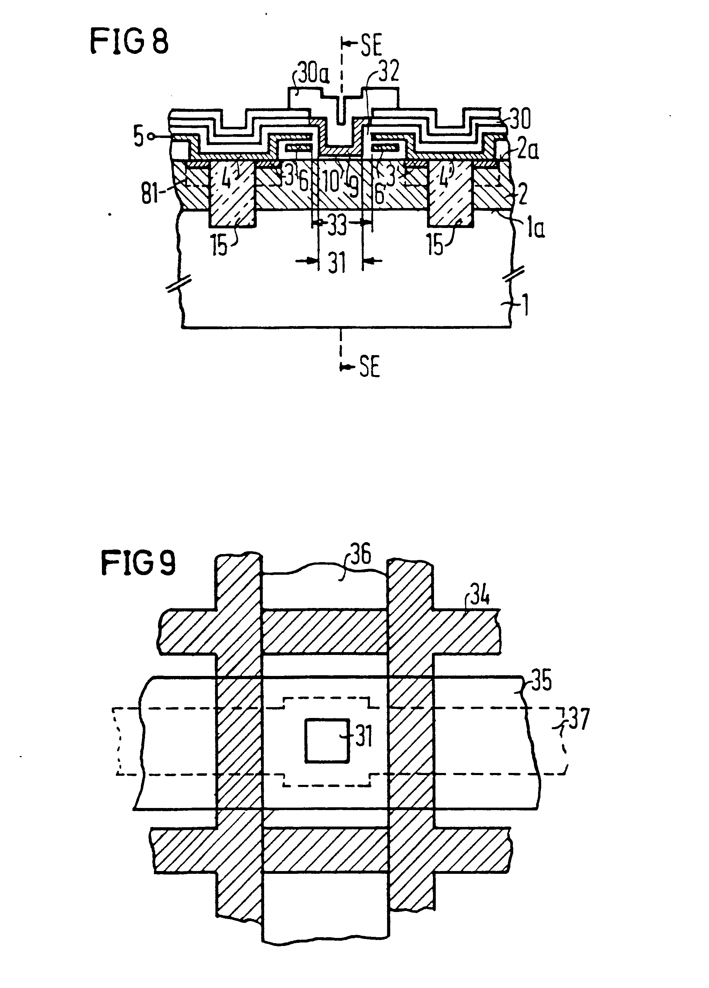

Fig.8   eine schematische Querschnittsdarstellung einer
Ausgestaltung der Speicherzelle nach Fig.1,

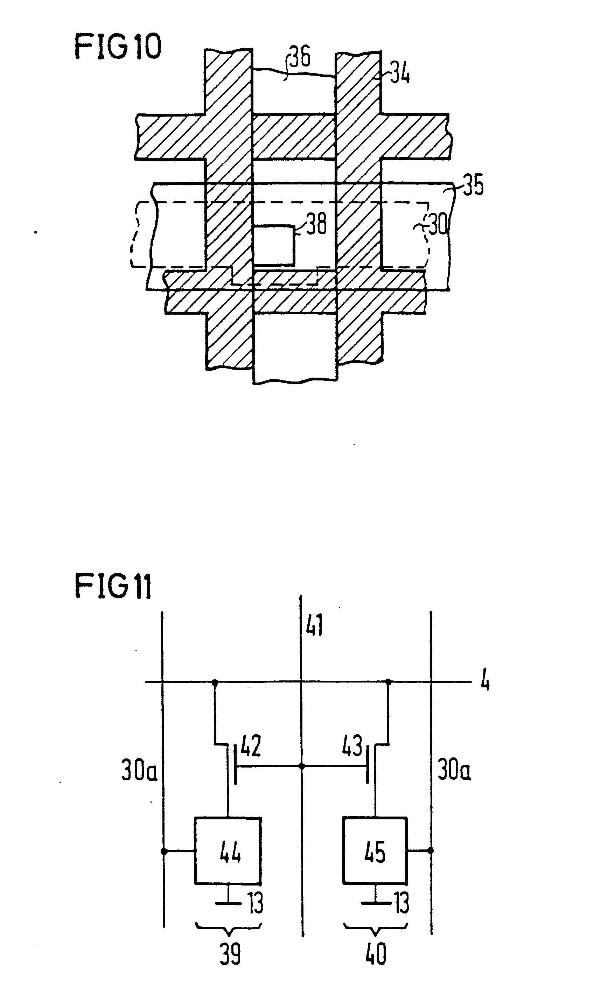

Fig.9   eine Darstellung des lay-out der Ausgestaltung
nach Fig.8,

Fig.10  eine Darstellung des lay-out einer alternativen
Ausgestaltung zu Fig.8 und

Fig.11  eine schematische Darstellung der Organisation
eines mit erfindungsgemäßen Speicherzellen aufgebauten Halbleiterspeichers.

Fig.12  einzelne Zwischenstufen der Speicherzelle wäh-
bis 16  rend des erfindungsgemäßen Herstellungsverfahrens,

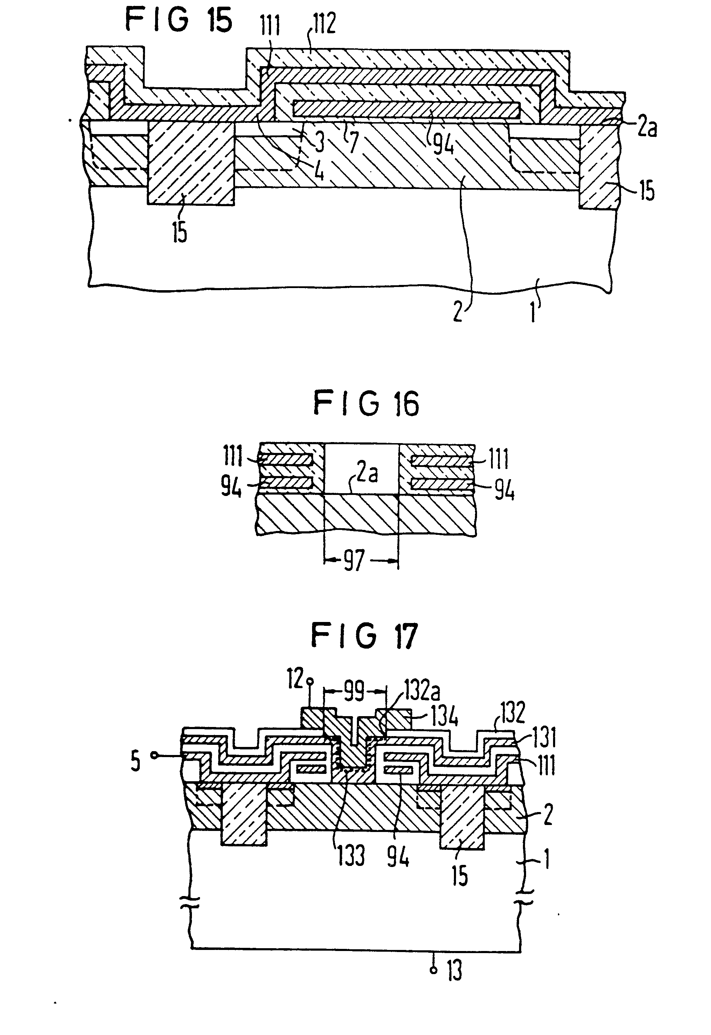

Fig.17 einen Querschnitt durch einen Teil der nach dem Verfahren gemäß Anspruch 1 hergestellten Speicherzelle,

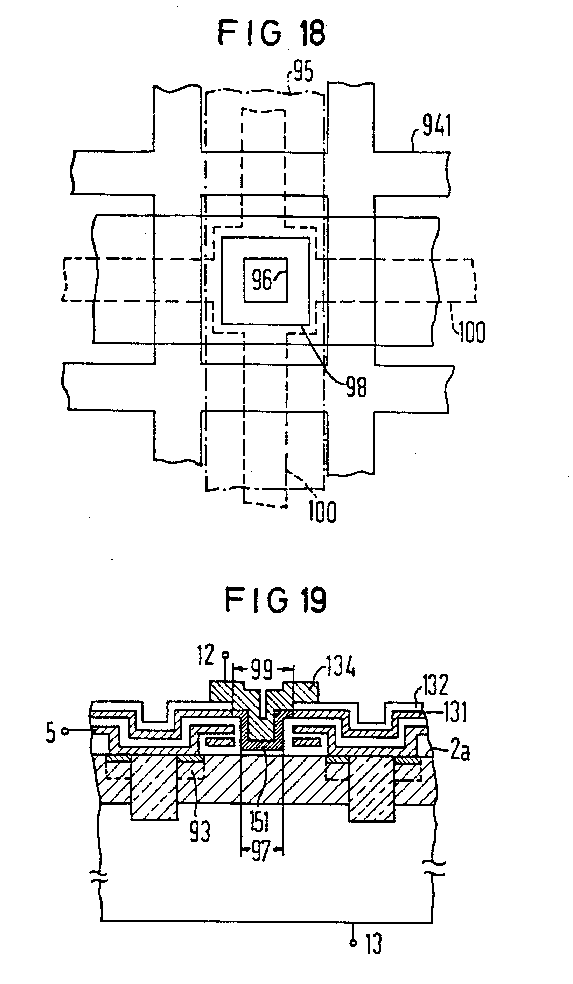

Fig.18 eine Darstellung der Masken, die bei einzelnen Verfahrensschritten benötigt werden, und

Fig.19 einen Querschnitt durch einen Teil der nach dem Verfahren gemäß Anspruch 2 hergestellten Speicherzelle.

Die Speicherzelle nach Fig. 1 ist auf einem dotierten Halbleiterkörper 1, z.B. aus n-leitendem Silizium, aufgebaut, der mit einer Halbleiterschicht 2 entgegengesetzter Leitfähigkeit, z.B. aus p-leitendem Silizium, abgedeckt ist. An der Grenzfläche 2a dieser Schicht befindet sich ein zu dieser entgegengesetzt dotiertes Gebiet 3, das bei dem genannten Beispiel n-leitend ist. Eine erste Ansteuerleitung (Bitleitung), die als eine leitende Belegung 4 mit einem Anschluß 5 dargestellt ist, kontaktiert das Gebiet 3. Neben dem Gebiet 3 ist ein Gate 6 angeordnet, das durch eine Gateisolierung 7 von der Grenzfläche 2a getrennt ist und durch seitliche Teile der die Gateisolierung darstellenden Schicht, die z.B. aus $SiO_2$ besteht, auch in lateraler Richtung gegenüber den angrenzenden Schaltungsteilen elektrisch isoliert ist. Das Gate 6 stellt einen Teil einer zweiten Ansteuerleitung (Wortleitung) dar, die einen endseitigen Anschluß 8 aufweist, oder ist über diesen Anschluß 8 mit einer Wortleitung verbunden. Neben dem Gate 6 ist eine elektrisch leitende Belegung 9 vorgesehen, die durch eine sehr dünne elektrisch isolierende Schicht 10, z.B. aus $SiO_2$, von der Oberfläche 2a getrennt ist. Die Dicke der Schicht 10 ist dabei so gewählt, daß sie einen Tunnelstrom zwischen der Grenzfläche 2a und der leitenden Belegung 9 zuläßt. Letztere ist über ein Lastelement, das in Fig.1 durch ein Widerstandssymbol angedeutet ist, mit einem Anschluß 12 verbunden, der mit einer Spannung $V_D$ beschaltet ist. Der Halbleiterkörper 1 ist mit einem Anschluß 13 versehen, dem eine Spannung $V_{Sub}$ zugeführt wird. Die Speicherzelle ist von einer grabenförmigen Ausnehmung 14 umgeben, die sich von der Grenzfläche 2a bis in den Halbleiterkörper 1 hinein erstreckt und mit einer elektrisch isolierenden Schicht, insbesondere Oxidschicht 15, ausgefüllt ist. Die Schaltungsteile 14, 15 können auch durch eine in vertikaler Richtung von der Grenzfläche 2a bis zur Grenzfläche 1a reichende und in lateraler Richtung etwa den Abmessungen der Ausnehmung 14 entsprechende Halbleiterzone ersetzt sein, deren Leitfähigkeitstyp dem des Halbleiterkörpers 1 entspricht.

Fig.2 zeigt zunächst einen ersten Betriebszustand der in Fig.1 schematisch dargestellten Speicherzelle. Die dem Anschluß 12 ständig zugeführte Spannung $V_D$ bewirkt den Aufbau einer Raumladungszone 16 unterhalb der leitenden Belegung 9. Die in dieser Zone 16 thermisch erzeugten negativen Ladungsträger gelangen unter dem Einfluß des in der Zone herrschenden elektrischen Feldes zur Grenzfläche 2a, während die positiven Ladungsträger 18 dem Anschluß 13 zugeführt werden. Die sehr dünne isolierende Schicht 10 erlaubt das Hindurchtreten der negativen Ladungsträger 17, die dann weiterhin dem Anschluß 12 zugeführt werden, so daß zwischen den Anschlüssen 12 und 13 ein auf die Ladungsträger 17 und 18 zurückgehender Generationsstrom fließt.

Der in Fig.3 dargestellte Betriebszustand unterscheidet sich von dem nach Fig.2 dadurch, daß sich an der Grenzfläche 2a unterhalb der leitenden Belegung 9 eine Inversionsschicht bzw. Inversionsladung 19 befindet, unter deren Einfluß sich die Raumladungszone 16 verringert. Die Schaltungsteile 19, 2 und 1 stellen einen bipolaren Transistor dar, dessen Emitterzone durch den Halbleiterkörper 1 und dessen Basiszone durch die Halbleiterschicht 2 gebildet werden. Der Kollektor dieses Transistors wird durch die Inversionsschicht 19 dargestellt. Unter dem Einfluß der Spannung $V_D$ entsteht ein durch den Pfeil 20 angedeuteter Injektionsstrom aus negativen Ladungsträgern, die vom Halbleiterkörper 1 über die Grenzfläche 1a in die Schicht 2 injiziert werden und zum Inversionskollektor 19 gelangen. Es entsteht ein wesentlich größerer Tunnelstrom durch die isolierende Schicht 10 als bei dem Betriebszustand nach Fig.2, wobei die negativen Ladungsträger wieder zum Anschluß 12 gelangen.  Zwischen den Anschlüssen 12 und 13 besteht somit ein Injektionsstrom,
dessen Größe durch den Tunnelstrom bestimmt ist.

Fig.4 zeigt einen Potentialverlauf $\emptyset$ entlang der Linie
A-A in Fig.2, Fig.5 im oberen Teil einen diese Linie enthaltenden Querschnitt durch die Anordnung nach Fig.2, der
senkrecht zur Bildebene von Fig.2 verläuft.  Die Schaltungsteile 1, 2 und 9 bis 13 der Fig.5 sind bereits anhand
der Fig.1 und 2 beschrieben.  Der in Fig.4 über der Entfernung z von dem oberen Ende des Lastelementes 11 aufgetragene Potentialverlauf $\emptyset$ läßt erkennen, daß der kleine
Generationsstrom an dem Lastelement 11 einen sehr kleinen
Potentialabfall bewirkt, während der an der Isolierschicht
10 entstehende Potentialabfall mit 20 bezeichnet ist.
In der Raumladungszone 16 fällt das Potential $\emptyset$ bis auf
das Potential $\emptyset 1$ der Halbleiterschicht 2 ab, während es
in der Raumladungszone 21, die sich zusammen mit der Raumladungszone 22 an der Grenzfläche 1a aufbaut, einen Potentialanstieg 23 etwa auf den Wert 24 gibt, der dem Potential des Halbleiterkörpers 1 entspricht.

Fig.6 zeigt den Potentialverlauf $\emptyset$ entlang der Linie B-B
in Fig.3 in einem Fig.4 entsprechenden Diagramm, wobei
nunmehr eine kleinere Raumladungszone 16' zu berücksichtigen ist, was in Fig.5 angedeutet ist.  Der wesentlich
größere Injektionsstrom ergibt dabei einen Spannungsabfall
25 im Lastelement 11, einen vergrößerten Spannungsabfall
20' an der Isolierschicht 10, einen verringerten Spannungsabfall innerhalb von 16' auf den nunmehr um die Flußspannung FS erhöhten Wert $\emptyset 1'$ der Schicht 2 und einen verkleinerten Potentialanstieg 23' etwa auf den Wert 24, der
wieder dem Potential des Halbleiterkörpers 1 entspricht.

In Fig.7 ist die Strom-Spannungs-Kennlinie eines aus den Teilen 2, 16, 10 und 9 bestehenden bistabilen Elements dargestellt. In diesem Diagramm ist der durch das Element fließende Strom I über der an die Teile 2 und 9 angelegten Spannung V aufgetragen. Die Kennlinie besitzt zwei Äste 25 und 26, die zusammen mit einer dem Lastelement 11 entsprechenden Widerstandslinie 27 zwei Schnittpunkte 28 und 29 ergeben. Jeder dieser Schnittpunkte stellt einen stabilen Arbeitspunkt des Tunnelelementes dar.

Das Element 10, 9, 16 und 2 bildet zusammen mit 11 und dem Halbleiterkörper 1 eine Teilschaltung, die in zwei stabilen, durch die Arbeitspunkte 28 und 29 definierten Schaltzuständen betrieben wird, wobei die Auswahl zwischen den Arbeitspunkten 28 und 29 durch die Größe des zwischen den Anschlüssen 12 und 13 fließenden Stromes erfolgt. Ist keine Inversionsladung 19 vorhanden (Fig2), so fließt ein kleiner Generationsstrom, der über die Kennlinie nach Fig.7 eine Einstellung auf die Spannung 20 bzw. auf den Arbeitspunkt 28 bewirkt. Bei einer gemäß Fig.3 vorhandenen Inversionsladung stellt sich durch den vorhandenen großen Injektionsstrom, der eine Spannung 20' über der Isolierschicht 10 abfallen läßt, der Arbeitspunkt 29 ein. Hierbei verhindert der Injektionsstrom einen Abbau der Inversionsladung 19, während im ersten Fall der dem Generationsstrom entsprechende kleine Tunnelstrom den Aufbau einer unerwünschten Inversionsladung an der Grenzfläche 2a unterhalb der leitenden Belegung 9 verhindert.

Das Speicherelement wird nun so betrieben, daß zum Einschreiben einer ersten digitalen Information, die z.B. durch eine logische "0" gegeben ist, die Bitleitung 4 über den Anschluß 5 auf ein hohes Potential $V_0$ gelegt

wird. Die Wortleitung 6 wird über ihren Anschluß 8 mit einer Gatespannung $V_G$ beschaltet, die die Halbleiterschicht unterhalb von 6 invertiert und den Aufbau eines Transferkanals an der Grenzfläche 2a zur Folge hat. Die am Anschluß 12 liegende Spannung $V_D$ erzeugt ein Oberflächenpotential an der Grenzfläche 2a unterhalb der Belegung 9, das kleiner ist als das Potential des mit der Bitleitung 4 verbundenen Gebietes 3. Daher werden keine Ladungsträger aus dem Gebiet 3 an die Grenzfläche 2a unterhalb von 10 transportiert und es bildet sich dort keine Inversionsladung aus. Damit entsteht der anhand von Fig.2 erläuterte Betriebszustand, in dem ein kleiner Generationsstrom fließt und der Arbeitspunkt 28 eingestellt ist. Nach dem Einschreiben der digitalen Information wird $V_G$ abgeschaltet und die Bitleitung 4 damit vom Speicherelement getrennt.

Zum Einschreiben der zweiten digitalen Information, die z.B. durch eine logische "1" gegeben ist, wird die Bitleitung 4 über den Anschluß 5 mit einer niedrigen Spannung $V_1$ beschaltet. Dem Anschluß 8 wird wieder die einen Transferkanal erzeugende Gatespannung $V_G$ zugeführt. Dabei werden Ladungsträger aus dem Gebiet 3 in die Halbleiterschicht 2 injiziert und sammeln sich unter der mit $V_D$ beschalteten Belegung 9 in Form einer Inversionsladung an. Es ergibt sich der Betriebszustand gemäß Fig.3, in dem ein großer Injektionsstrom fließt, der dem Arbeitspunkt 29 entspricht. Durch diesen Injektionsstrom wird die Inversionsladung nach dem Abschalten von $V_G$ bzw. dem Abtrennen der Bitleitung 4 vom Speicherelement aufrechterhalten.

Die gespeicherte digitale Information, die sich aus dem Vorhandensein oder Nichtvorhandensein der Inversionsladung 19 ergibt, wird nunmehr durch die stationären Arbeitspunkte 28 und 29 aufrechterhalten, ohne periodisch
regeneriert werden zu müssen.

Zum Auslesen der gespeicherten Information wird die Bitleitung 4 zunächst auf ein Referenzpotential rückgesetzt
und anschließend von äußeren Potentialen freigeschaltet,
so daß sie sich in einem Zustand des "floating" befindet.
Anschließend wird das Gate 6 wieder mit der Gatespannung
$V_G$ beaufschlagt. Unterschiedliche Potentialänderungen,
die auf der Bitleitung 4 in Abhängigkeit vom Vorhandensein oder Nichtvorhandensein einer Inversionsladung 19
entstehen, werden als Auslesesignale für unterschiedliche
gespeicherte digitale Informationen bewertet, indem sie
dem Gate eines eingangsseitigen Feldeffekttransistors
einer Bewerterstufe zugeführt werden und den durch diesen
fließenden Strom beeinflussen, dessen an einem Lastelement entstehender Spannungsabfall einer weiteren logischen Verarbeitung zugrunde gelegt werden kann. Zweckmäßigerweise wird die Bitleitung 4 zum Auslesen auf ein
hohes Referenzpotential rückgesetzt, so daß beim Auslesen
einer logischen "1" durch die in 3 eindringenden Ladungsträger ein deutlicher Spannungsabfall auf der Bitleitung
4 entsteht, während beim Auslesen einer logischen "0"
mangels einer Inversionsladung 19 das Rücksetzpotential
auf der Bitleitung 4 erhalten bleibt.

In Fig.8 ist eine vorteilhafte Ausgestaltung einer Speicherzelle nach der Erfindung im Schnitt dargestellt.
Das Gate 6 ist als ein Teil einer leitenden Belegung
einer ersten Belegungsebene ausgebildet, die die Wortleitung darstellt. Die Bitleitung 4 besteht aus einer
leitenden Belegung in Form eines mäanderförmigen Streifens, der das Gebiet 3 kontaktiert und außerhalb des
Kontaktbereiches in einer zweiten Belegungsebene verläuft.
Ein Teil einer weiteren mäanderförmigen              Bele-

gung 30 stellt die Belegung 9 (Fig.1) dar. Die Belegungen 6, 4 bestehen vorzugsweise aus hochdotiertem, polykristallinem Silizium und sind durch isolierende Zwischenschichten 32, vorzugsweise aus $SiO_2$, voneinander getrennt. In einer Ausnehmung 31 der isolierenden Zwischenschichten 32, die innerhalb einer Ausnehmung 33 der Belegungen 4 und 6 liegt und bis auf die mit der sehr dünnen isolierenden Schicht 10 bedeckte Grenzfläche 2a reicht, ist die Belegung 30 bis an diese Schicht 10 geführt. Zur Bildung des Lastelementes 11 kann die Belegung 30 im Bereich der Ausnehmung 31 schwach dotiert sein, während sie in ihren übrigen Teilen undotiert ist. Je stärker diese Dotierung ist, umso kleiner ist der Widerstand des Lastelementes. Die Verbindung von dem Lastelement 11 zu dem Anschluß 12 erfolgt in Fig.8 über eine streifenförmige Metallisierung 30a, die parallel oder senkrecht zur Bildebene verläuft.

In Fig.8 ist eine symmetrische Weiterbildung der Anordnung nach Fig.1 dargestellt, bei der links und rechts von einer mittleren Symmetrieebene SE zwei Transferelemente 3-8 bzw. 3'-8' angeordnet sind, die an eine gemeinsame dünne isolierende Schicht 10 und eine gemeinsame leitende Belegung 9 angrenzen.

Fig.9 zeigt das lay-out einer Anordnung nach Fig.8. Dabei sind die Isolationszonen 14, 15 durch schraffierte Streifen 34 angedeutet, während die Wortleitung 6 durch einen Streifen 35, die Bitleitung 4 durch einen Streifen 36 und die Belegung 30 durch einen Streifen 37 gekennzeichnet sind. Die Ausnehmung 31 in Fig.8 ist in Fig.9 entsprechend gekennzeichnet. In dem alternativen lay-out nach Fig.10 ist eine Ausnehmung 38 vorgesehen, die der Ausnehmung 31 entspricht, jedoch in einer Ecke der für eine Speicherzelle vorgesehenen, von den Isolationszonen 14, 15 eingeschlossenen Halbleiterfläche liegt.

In Fig.11 ist eine zweckmäßige Organisationsform einer aus Speicherzellen nach der Erfindung aufgebauten Speichermatrix angegeben. Die Transferelemente der Speicherzellen sind mit 42 und 43 bezeichnet, während die bistabilen Schaltungen 1, 2, 9, 10 und 11 der Speicherzellen durch die Blöcke 44 und 45 angedeutet sind. Die in einer Matrixzeile liegenden Speicherzellen 39 und 40 weisen eine gemeinsame Bitleitung 4 auf, die in einer Spalte zusammengefaßten Speicherzellen gemeinsame Wortleitungen 6, die im Fall der Fig.11 durch eine zwischen zwei Spalten liegende, allen Speicherzellen dieser beiden Spalten gemeinsame Wortleitung 41 dargestellt werden. Die streifenförmigen Metallisierungen 30a verlaufen parallel zu den Wortleitungen 41, während die Masseanschlüsse der bistabilen Teilschaltungen 44, 45 durch den Anschluß 13 des Halbleiterkörpers 1 gebildet werden.

Soll bei der Ausgestaltung nach Fig.8 das Lastelement 11 einen kleinen Widerstand aufweisen oder ganz wegfallen, so wird der im Bereich der Ausnehmung 31 liegende Teil der aus Polysilizium gebildeten Belegung 30 stark dotiert. Bei einer schwachen Dotierung stellt dieser Teil der Belegung 30 ein Element dar, das den Teilen 9 und 11 von Fig.1 entspricht. Andererseits kann in Fig.8 die Schicht 10 wegfallen, wenn der die Grenzfläche 2a dann kontaktierende Teil der polykristallinen Belegung 30 undotiert bleibt.

Die dünne isolierende Schicht 10 kann beispielsweise durch eine $SiO_2$-Schicht mit einer Schicktdicke von etwa 30-60 Å oder durch eine undotierte Polysiliziumschicht mit einer Schichtdicke in der Größenordnung von 4000 Å realisiert werden.

Für den Fall, daß die Schicht 10 in Fig.8 fehlt, kann der die Grenzfläche 2a berührende Teil der polykristallinen Belegung 30 so ausgebildet sein, daß er an seiner der streifenförmigen Metallisierung zugewandten Fläche eine durch die gestrichelte Linie 50 angedeutete schwache Dotierung erhält, so daß die Grenzfläche zwischen den Teilen 30 und 30a im Bereich dieser Dotierung einen in Durchlaßrichtung betriebenen Schottky-Übergang darstellt, der dem Lastelement 11 entspricht.

Zweckmäßigerweise erhält eine mit 81 (Fig.1, Fig.8) bezeichnete Zone der Halbleiterschicht 2 eine stärkere Dotierung als der übrige Teil der Zone 2, um eine unerwünschte npn-Transistoraktion zwischen den Teilen 1, 2 und 3 zu unterbinden, bei der vom Halbleiterkörper 1 injizierte Ladungsträger über die Halbleiterschicht 2 in das Gebiet 3 gelangen. Eine den Teilen 1, 2, 9, 10, 11 und 12 entsprechende Anordnung ist in dem Aufsatz "Steady-State Characteristics of Tow Terminal Inversion-Controlled Switches" von H. Kroger und Richard Wegener, abgedruckt in Solid State Electronics, 1978, Vol.21, Seiten 643-654, beschrieben.

Die angegebenen Spannungen und Potentiale haben gegenüber dem Potential am Anschluß 13 ein positives Vorzeichen, wenn der Halbleiterkörper 1 n-leitend und die Halbleiterschicht p-leitend ausgebildet sind. Werden die Leitfähigkeitstypen der einzelnen Halbleitergebiete durch die entgegengesetzten ersetzt, so erhalten die auf das Potential am Anschluß 13 bezogenen Spannungen und Potentiale ein negatives Vorzeichen.

Bei der erfindungsgemäßen Herstellung der Speicherzelle wird, wie Fig. 12 zeigt, von einem Halbleiterkörper 1 ausgegangen, auf dem eine Halbleiterschicht 2 angeordnet ist. Der Halbleiterkörper 1 besteht z.B. aus n-leitendem Silizium mit einer Dotierungskonzentration von etwa $10^{19}\,cm^{-3}$, wobei die Halbleiterschicht 2 dann aus p-leitendem Silizium besteht, das eine Dotierungskonzentration von etwa $5 \cdot 10^{15}\,cm^{-3}$ aufweist. In dieser werden durch eine erste Maske 941 definierte grabenförmige Ausnehmungen 14 vorgesehen, was vorzugsweise mit einer selektiven, vertikal ausgerichteten, reaktiven Plasma-Ätzung geschieht. Diese Ausnehmungen 14 werden anschließend mit einem Isolationsmaterial 15 aufgefüllt, beispielsweise im Verlauf einer thermischen Oxidation mit $SiO_2$, wobei das über die Grenzfläche 2a hinausragende Material wieder entfernt wird, beispielsweise durch einen weiteren Ätzvorgang. Es folgt ein Oxidationsschritt zum Aufbringen einer $SiO_2$-Gateoxidschicht 7 (Fig. 13). Anschließend wird eine polykristalline Siliziumschicht 94 ganzzflächig aufgebracht, mit Donatoren hoch dotiert und durch eine Zwischenoxidschicht 91 aus $SiO_2$ abgedeckt. Durch eine zweite Maske 92, z.B. aus Fotolack, werden die lateralen Begrenzungen des Gate 6 und der angeschlossenen Wortleitung definiert und durch eine selekt ive, vertikal ausgerichtete, reaktive Plasma-Ätzung strukturiert. Vor dem Entfernen der zweiten Maske folgt eine Implantation von Donatorionen, z.B. Arsen, um das n-leitende Gebiet 3 zu bilden, und gegebenenfalls eine Implantation von Akzeptorionen, um unterhalb des Gebietes 3 die Dotierung der Schicht 2 in einer Zone 93 zu erhöhen. In einem isotropen Ätzschritt werden anschließend die endseitigen Abschnitte 94a der polykristallinen Siliziumschicht 94 herausgeätzt und in
einem thermischen Oxidationsschritt mit $SiO_2$ wieder
aufgefüllt. In einem vertikal ausgerichteten reaktiven
Plasma-Ätzschritt wird die Gateoxidschicht 7 entfernt,
wobei eine Struktur gemäß Fig. 14 entsteht.

Es folgt eine weitere Abscheidung einer polykristallinen Siliziumschicht 111, die stark mit Donatoren dotiert und anschließend mit einer Zwischenoxidschicht
112 aus $SiO_2$ abgedeckt wird. Mittels einer selektiven,
vertikal ausgerichteten, reaktiven Plasma-Ätzung,
durch die gemäß einer dritten Maske 95 die erste Ansteuerleitung einschließlich ihres das Gebiet 3 kontaktierenden Teils 4 strukturiert wird. Es folgt eine
reaktive Plasma-Ätzung, bei der die innerhalb der
Öffnung 97 (Fig. 16) einer vierten Maske 96 liegenden
Teile der polykristallinen Siliziumschichten 94 und
111 sowie die Zwischenoxidschichten und die Gateoxidschicht 7 bis zur Grenzfläche 2a entfernt werden. In
einem folgenden, isotropen Ätzschritt werden dann die
in die Öffnung 97 mündenden endseitigen Abschnitte der
streifenförmigen polykristallinen Siliziumschichten 94
und 111 entfernt und die entstehenden Ausnehmungen
durch eine thermische Oxidation mit $SiO_2$ aufgefüllt.
In einer vertikal ausgerichteten, raktiven Plasma-
Ätzung wird sodann das innerhalb der Öffnung 97 auf
der Grenzfläche 2a gebildete $SiO_2$ entfernt.

Dann folgt eine weitere Abscheidung einer Schicht 131
aus polykristallinem Silizium, die zunächst nicht dotiert wird. Sie wird mit einer Zwischenoxidschicht
132 abgedeckt. Auf dieser wird eine fünfte Maske 98
angebracht, die eine Öffnung 99 aufweist, die etwas
größer sein kann als die Öffnung 97. Durch eine reaktive Plasma-Ätzung wird der Teil der Zwischenoxidschicht 132, der innerhalb der Öffnung 99 liegt, entfernt. Es folgt eine schwache Implantation von Donatorionen, z.B. Arsenionen, in die Oberfläche der Schicht
131, und zwar lediglich innerhalb der Öffnung 99. Die
beeinflußte Oberfläche von 131 ist in Fig. 17 mit 133
bezeichnet. Nach dem Entfernen der fünften Maske erfolgt schließlich das Auftragen einer leitenden Belegung 134, deren Struktur mittels eines Maskierungsschrittes (sechste Maske 100) durchgeführt wird. Der
in Fig. 17 eingezeichnete Teil dieser leitenden
Belegung/134 kann sich in Form eines Streifens entweder
senkrecht zur Bildebene von Fig. 17 oder parallel zu
dieser Bildebene fortsetzen. Die einzelnen Masken
sind in Fig. 18 übereinanderliegend dargestellt und
durch verschiedene Stricharten gekennzeichnet. Die
Struktur nach Fig. 17, die durch die Anschlüsse 12,
5 und 8 (Fig. 1) ergänzt wird, bildet dann eine nach
der Erfindung hergestellte statische Speicherzelle.

Nach einer Variante des vorstehend beschriebenen Verfahrens kann die oberflächenseitige Implantation der
polykristallinen Siliziumschicht 131 mit Donatorionen, die mit 133 bezeichnet ist, auch entfallen.

Wenn die schwache Dotierung 133 erfolgt, so stellt
der undotierte Teil der Schicht 131, der innerhalb
der Öffnung 99 liegt, die dünne isolierende Schicht
10 von Fig. 1 dar, deren Dicke etwa in der Größenordnung von 4000 Å liegt. Da die leitende Belegung
134 auf dem Teil der Schicht 131 angeordnet ist, der
innerhalb der Öffnung 99 liegt, entsteht im Bereich
von 133 ein in Durchlaßrichtung betriebener Schottky-
Übergang, der das Lastelement 11 (Fig. 1) darstellt.
Die leitende Belegung 134 bildet dann die Verbindung
zu dem Anschluß 12.

Nach einer anderen Variante des beschriebenen Verfahrens wird nach der reaktiven Plasma-Ätzung mit der die SiO$_2$-Schicht aus dem Innern der Öffnung 97 weggeätzt wird, zunächst eine dünne isolierende Schicht 151, vorzugsweise aus SiO$_2$, mit einer Schichtdicke von etwa 30 bis 60 Å durch eine thermische Oxidation auf der Grenzfläche 2a innerhalb der Öffnung 97 aufgebracht. Es folgt der bereits beschriebene Verfahrensschritt zum Aufbringen der undotierten polykristallinen Siliziumschicht 131 und der sie abdeckenden Zwischenoxidschicht 132. Im Anschluß daran wird eine fünfte Maske 98 aufgebracht und der innerhalb der Öffnung 99 befindliche Teil der Schicht 132 mittels eines reaktiven Plasma-Ätzschrittes entfernt. Im Unterschied zu dem zuerst beschriebenen Verfahren schließt sich eine Implantation von Donatorionen in den innerhalb der Öffnung 99 liegenden Abschnitt der nicht dotierten polykristallinen Siliziumschicht 131 an, wobei eine solche Implantationsenergie verwendet wird, daß dieser Abschnitt der Schicht 131 bis zur Grenzfläche gegenüber der Isolierschicht 151 dotiert wird. Dann wird die metallisch leitende Schicht 134 aufgebracht und mittels der in Fig. 18 dargestellten Maske 100 strukturiert. Schließlich werden wieder die Anschlüsse 12, 5 und 8 angebracht. In der dabei erhaltenen Ausführung der Speicherzelle, die in Fig. 19 gezeigt ist, wird die dünne isolierende Schicht 10 von Fig. 1 durch die aufgebrachte SiO$_2$-Schicht 151 gebildet.

Der auch bei dieser Variante des Verfahrens an der Grenzfläche der Schichten 131 und 134 entstandene Schottky-Übergang stellt das Lastelement 11 (Fig. 1) dar.

Die Zone 93 der Halbleiterschicht 2 wird, wie bereits angedeutet, mit einer Zusatzdotierung versehen, sodaß sie einen stärkeren Dotierungsgrad aufweist als die übrigen Teile der Schicht 2. Dies geschieht, um eine npn-Transistoraktion zwischen den Teilen 1, 2 und 3 zu unterbinden. Hierbei würden Ladungsträger, die aus dem Halbleiterkörper 1 in die Schicht 2 injiziert werden, in das Gebiet 3 gelangen und das Potential auf der ersten Ansteuerleitung beeinflussen.

In mehreren Verfahrensschritten tritt ein selektiver vertikal ausgerichteter, reaktiver Plasma-Ätzvorgang auf, bei dem das Ätzmittel aus einem schwach inonisierten Gas besteht, das vor allem in einer durch ein angelegtes elektrisches Feld bestimmten Richtung auf eine Ätzprobe einwirkt. Ein solches Ätzverfahren, mit dem sich vertikale Kanten von einzelnen Strukturen oder Ausnehmungen erzielen lassen, ist beispielsweise aus dem Aufsatz "Some Chemical Aspects of the Fluor Carben Plasma Etching of Silicon and its Compounds" abgedruckt in Solid State Technology, Vol. 4, Seiten 117 - 124, 1979 und dem Aufsatz "Anisotropic Plasma Etching of Semiconductor Materials", Solid State Technology, Vol. 4, Seiten 125 - 132, 1979, bekannt.

In Abweichung von der Beschreibung zu Fig. 12 kann anstelle der durch die Teile 14, 15 gebildeten Oxidisolation der Speicherzelle auch eine Sperrschicht-Isolation verwendet werden. In diesem Fall stellt 15 ein $n^+$-leitendes Gebiet dar, das bis zu der Grenzfläche 1a zwischen den Teilen 1 und 2 reicht. Die Dotierung des Gebietes 15 erfolgt durch Diffusion oder Implantation.

Die Halbleiterschicht 2 kann entweder eine Epitaxieschicht sein, die auf dem Halbleiterkörper abgeschieden wird, oder als Diffusionsgebiet des Halbleiterkörpers aufgefaßt werden.

Die oben angegebenen Spannungen und Potentiale haben gegenüber dem Potential am Anschluß 13 (Fig.1) ein positives Vorzeichen, wenn der Halbleiterkörper 1 n-leitend und die Halbleiterschicht 2 p-leitend ausgebildet sind. Werden die Leitfähigkeitstypen der einzelnen Halbleitergebiete durch die entgegengesetzten ersetzt, so erhalten die auf das Potential am Anschluß 13 bezogenen Spannungen und Potentiale ein negatives Vorzeichen.

21 Patentansprüche
19 Figuren

Patentansprüche

1. Monolithische statische Speicherzelle, d a d u r c h g e k e n n z e i c h n e t , daß auf einem mit einem ersten Anschluß (13) versehenen Halbleiterkörper (1) eines ersten Leitfähigkeitstyps eine Halbleiterschicht (2) eines zweiten Leitfähigkeitstyps angeordnet ist, daß an einer Grenzfläche (2a) der letzteren ein Gebiet (3) des ersten Leitfähigkeitstyps vorgesehen ist, das mit einer ersten Ansteuerleitung (4) verbunden ist, daß ein neben dem Gebiet (3) liegender erster Bereich der Halbleiterschicht (2) durch ein mit einer zweiten Ansteuerleitung (8) verbundenes Gate (6) überdeckt ist, das durch eine Gateisolation (7) von der Grenzfläche (2a) getrennt ist, daß ein neben dem ersten Bereich liegender zweiter Bereich der Halbleiterschicht (2) durch eine mit einem zweiten Anschluß (12) in Verbindung stehende, leitende Belegung (9) abgedeckt ist und daß die leitende Belegung (9) durch eine dünne, einen Tunnelstrom zwischen der Grenzfläche (2a) und der leitenden Belegung (9) zulassende, elektrisch isolierende Schicht (10) von der Grenzfläche (2a) getrennt ist.

2. Speicherzelle nach Anspruch 1, d a d u r c h g e k e n n z e i c h n e t , daß die leitende Belegung (9) über ein Lastelement (11) mit dem zweiten Anschluß (12) verbunden ist.

3. Speicherzelle nach Anspruch 2, d a d u r c h g e k e n n z e i c h n e t , daß das Lastelement (11) aus einer widerstandsbehafteten Schicht besteht, die auf der leitenden Belegung (9) aufgebracht ist.

4. Speicherzelle nach einem der Ansprüche 1 bis 3, d a d u r c h g e k e n n z e i c h n e t , daß sie von einer grabenförmigen Ausnehmung (14) umgeben ist, die sich von der Grenzfläche (2a) der Halbleiterschicht (2) bis in den Halbleiterkörper (1) hinein erstreckt und mit einer elektrisch isolierenden Schicht (15), insbesondere Oxidschicht, ausgefüllt ist.

5. Speicherzelle nach einem der Ansprüche 1 bis 3, d a d u r c h g e k e n n z e i c h n e t , daß sie von einer Zone des ersten Leitfähigkeitstyps umgeben ist, die sich von der Grenzfläche der Halbleiterschicht (2a) bis zur nächstliegenden Grenzfläche (1a) des Halbleiterkörpers (1) erstreckt.

6. Speicherzelle nach einem der Ansprüche 1 bis 5, dadurch g e k e n n z e i c h n e t , daß die erste Ansteuerleitung (4) aus einer ersten streifenförmigen leitenden Belegung einer zweiten Belegungsebene besteht, die das Gebiet (3) kontaktiert und oberhalb der zweiten Ansteuerleitung (6) liegt, welche aus einer zweiten streifenförmigen leitenden Belegung einer ersten Belegungsebene besteht, daß die mit dem zweiten Anschluß (12) in Verbindung stehende leitende Belegung (9) aus einem dotierten Teil einer weiteren streifenförmigen Belegung (30) besteht, der innerhalb einer randseitig isolierten Ausnehmung (31) der ersten und zweiten streifenförmigen leitenden Belegungen auf der den Boden der Ausnehmung (31) bildenden dünnen isolierenden Schicht (10) aufgebracht ist, daß die weitere streifenförmige Belegung (30) außerhalb der Ausnehmung (31) in einer dritten Belegungsebene verläuft und daß oberhalb des genannten dotierten Teils der weiteren streifenförmigen Belegung (30) eine streifenförmige leitende Belegung (30a) vorgesehen ist, die mit dem zweiten Anschluß (12) verbunden ist.

7. Speicherzelle nach Anspruch 6, dadurch g e k e n n z e i c h n e t , daß die Dotierung des Teils der weiteren streifenförmigen Belegung (30) so schwach ist, daß er auch das Lastelement (11) darstellt.

8. Speicherzelle nach einem der Ansprüche 1 bis 5, dadurch g e k e n n z e i c h n e t , daß die erste Ansteuerleitung (4) aus einer ersten streifenförmigen leitenden Belegung einer zweiten Belegungsebene besteht, die das Gebiet (3) kontaktiert und oberhalb der zweiten Ansteuerleitung (6) liegt, welche aus einer zweiten steifenförmigen leitenden Belegung einer ersten Belegungsebene besteht, daß ein Teil einer aus undotiertem, polykristallinem Silizium bestehenden, weiteren streifenförmigen Belegung (30) innerhalb einer randseitig isolierten Ausnehmung (31) der ersten und zweiten streifenförmigen leitenden Belegungen auf der den Boden der Ausnehmung (31) bildenden Grenzfläche (2a) der Halbleiterschicht (2) aufgebracht ist, daß die weitere streifenförmige Belegung (30) außerhalb der Ausnehmung (31) in einer dritten Belegungsebene verläuft und daß die mit dem zweiten Anschluß (12) in Verbindung stehende leitende Belegung (9) aus einer streifenförmigen leitenden Belegung (30a) besteht, die oberhalb des genannten Teils der weiteren streifenförmigen Belegung (30) angeordnet ist.

9. Speicherzelle nach Anspruch 8, g e k e n n z e i c h n e t durch eine schwache Dotierung des auf der Grenzfläche (2a) aufgebrachten Teils der weiteren streifenförmigen Belegung (30) auf seiner der streifenförmigen leitenden Belegung (30a) zugewandten Seite (50).

10. Speicherzelle nach einem der Ansprüche 1 bis 9, dadurch g e k e n n z e i c h n e t , daß eine unter den

Gebiet (3) liegende Zone (31) der Halbleiterschicht (2) mit einem höheren Dotierungsgrad versehen ist als die übrigen Teile derselben.

11. Speicherzelle nach einem der Ansprüche 1 bis 7 und 10, dadurch g e k e n n z e i c h n e t , daß die dünne isolierende Schicht (10) aus einer Oxidschicht besteht.

12. Speicherzelle nach einem der Ansprüche 1 bis 5, 8 und 9, dadurch g e k e n n z e i c h n e t , daß die dünne isolierende Schicht (10) aus einer undotierten Polysiliziumschicht (30) besteht.

13. Speicherzelle nach einem der Ansprüche 1 bis 12, dadurch g e k e n n z e i c h n e t , daß sie mit weiteren, gleichartig aufgebauten Speicherzellen in den Reihen und Spalten einer Speichermatrix angeordnet ist, daß die Speicherzellen einer Zeile jeweils mit einer gemeinsamen ersten Ansteuerleitung (4) verbunden sind, daß die Speicherzellen einer Spalte jeweils mit einer gemeinsamen zweiten Ansteuerleitung (6) beschaltet sind, und daß die zweiten Anschlüsse (12) der Speicherzellen einer Spalte jeweils mit einer gemeinsamen Spannungszuführungsleitung (30a) verbunden sind.

14. Verfahren zum Betrieb einer Speicherzelle nach einem der vorhergehenden Ansprüche, dadurch g e k e n n z e i c h n e t , daß zum Einschreiben einer digitalen Information erster Art das Gate (6) mit einer Gatespannung ($U_G$) beschaltet wird, durch die an der Grenzfläche (2a) des ersten Bereiches ein Inversionskanal entsteht, wobei das Gebiet (3) mit einer so hohen Spannung ($U_0$) beschaltet wird, daß ein Transport von Ladungsträgern aus dem Gebiet (3) an die Grenzfläche (2a) des zweiten Bereiches unterbleibt, und wobei an den beiden Anschlüssen (12, 13) eine Spannung liegt, unter deren Einfluß an der Grenzfläche (2a) des zweiten Bereiches eine Raumladungszone (16) entsteht und zwischen den beiden Anschlüssen (12, 13) ein Generationsstrom erzeugt wird, der die dünne elektrisch isolierende Schicht (10) auf einen stationären Arbeitspunkt (28) eines kleinen Tunnelstromes einstellt, und daß zum Einschreiben einer digitalen Information zweiter Art das Gate (6) mit der genannten Gatespannung ($U_G$) beschaltet wird, wobei das Gebiet (3) mit einer so niedrigen Spannung ($U_1$) beschaltet wird, daß aus dem letzteren an die Grenzfläche (2a) des zweiten Bereiches transportierte Ladungsträger dort eine Inversionsschicht (19) bilden, und wobei durch die genannte, an den beiden Anschlüssen (12, 13) liegende Spannung zwischen diesen ein Injektionsstrom fließt, der die dünne elektrisch isolierende Schicht (10) auf einen stationären Arbeitspunkt (29) eines großen Tunnelstromes einstellt.

15. Verfahren nach Anspruch 14, dadurch g e k e n n - z e i c h n e t , daß zum Auslesen der gespeicherten Informationen die mit dem Gebiet (3) verbundene erste Ansteuerleitung (4) auf ein Referenzpotential rückgesetzt und anschließend von äußeren Potentialen freigeschaltet wird, daß das Gate (6) mit der genannten Gatespannung ($U_G$) beschaltet wird und daß unterschiedliche Potentialänderungen, die auf der ersten Ansteuerleitung (4) in Abhängigkeit vom Vorhandensein oder Nichtvorhandensein einer Inversionsschicht (19) entstehen, als Lesesignal für unterschiedliche gespeicherte digitale Informationen bewertet werden.

16. Verfahren zur Herstellung einer monolithischen statischen Speicherzelle, bei der auf einem mit einem ersten Anschluß versehenen Halbleiterkörper eines ersten Leitfähigkeitstyps eine Halbleiterschicht eines zweiten Leitfähigkeitstyps angeordnet ist, bei der an einer Grenzfläche der letzteren ein Gebiet des ersten Leitfähigkeitstyps vorgesehen ist, das mit einer ersten Ansteuerleitung verbunden ist, bei der ein neben dem Gebiet liegender erster Bereich der Halbleiterschicht durch ein mit einer zweiten Ansteuerleitung verbundenes Gate überdeckt ist, das durch eine Gateisolation von der Grenzfläche getrennt ist, bei der ein neben dem ersten Bereich liegender zweiter Bereich der Halbleiterschicht durch eine mit einem zweiten Anschluß in Verbindung stehende, leitende Belegung<sup>x)</sup> durch eine dünne, einen Tunnelstrom zwischen der Grenzfläche und der leitenden Belegung zulassende, elektrisch isolierende Schicht von der Grenzfläche getrennt ist, d a d u r c h  g e k e n n z e i c h - n e t , daß die Halbleiterschicht (2) mit streifenförmigen, sich bis zum Halbleiterkörper (1) erstreckenden, die Speicherzelle eingrenzenden Isolationszonen (14, 15) versehen wird, daß auf der Grenzfläche (2a) der Halbleiterschicht (2) eine Gateoxidschicht (7) aufgebracht wird, auf der eine Polysiliziumschicht (94) abgeschieden, stark dotiert und mit einer ersten Zwischenoxidschicht (91) bedeckt wird, daß die zweite Ansteuerleitung (94) und das Gate durch eine erste selektive, vertikal ausgerichtete, reaktive Plasmaätzung strukturiert werden, daß in einem isotropen Ätzschritt die endseitigen Abschnitte (94a) der zweiten Ansteuerleitung (94) entfernt und die entstehenden Ausnehmungen mit einem thermischen Oxidationsschritt aufgefüllt werden, daß der neben den strukturierten

<sup>x)</sup> abgedeckt ist und bei der die leitende Belegung

-25-    VPA 79 P 7131 EUR

Teilen (94) liegende Teil der Gateoxidschicht (7) durch eine zweite selektive, vertikal ausgerichtete, reaktive Plasmaätzung entfernt wird, daß eine zweite Polysiliziumschicht (111) abgeschieden, stark dotiert und mit einer zweiten Zwischenoxidschicht (112) abgedeckt wird, daß die erste Ansteuerleitung (4) einschließlich des das Gebiet (3) kontaktierenden Teils durch eine dritte selektive vertikal ausgerichtete, reaktive Plasmaätzung strukturiert wird, daß eine Dotierung des Gebietes (3) mittels einer Ionenimplantation vorgenommen wird, daß eine vierte vertikal ausgerichtete reaktive Plasmaätzung zur Bildung einer Ausnehmung (97) erfolgt, wobei sich ein isotroper Ätzschritt zur Entfernung der in die Ausnehmung mündenden Teile der ersten und zweiten Ansteuerleitung (94, 111) und eine thermische Oxidation zum Auffüllen der entstandenen Ausnehmungen anschließen, daß eine fünfte selektive, vertikal ausgerichtete reaktive Plasmaätzung zur Entfernung der die Grenzfläche 2a bedeckenden Oxidschicht innerhalb der Ausnehmung (97) durchgeführt wird, daß eine dritte Polysiliziumschicht (131) abgeschieden und mit einer dritten Zwischenoxidschicht (132) abgedeckt wird, daß mit einer sechsten selektiven reaktiven Plasmaätzung eine oberhalb der Ausnehmung (97) liegende Ausnehmung (132a) der dritten Zwischenoxidschicht (132) gebildet wird und daß auf der dritten Polysiliziumschicht (131) innerhalb der Ausnehmung (97 eine leitende Belegung (134) aufgebracht wird, die mit dem zweiten Anschluß (12) versehen wird.

17. Verfahren nach Anspruch 16, d a d u r c h  g e k e n n z e i c h n e t , daß eine oberflächenseitige Dotierung (133) der dritten Polysiliziumschicht (131) im Bereich der Ausnehmung (132a) mittels einer selektiven Ionenplantation erfolgt.

18. Verfahren nach Anspruch 16, d a d u r c h g e - k e n n z e i c h n e t , daß nach der fünften Plasmaätzung eine dünne isolierende Schicht (151) auf der Grenzfläche 2a der Halbleiterschicht 2 innerhalb der Öffnung (97) vorgesehen wird und daß eine Dotierung der dritten Polysiliziumschicht (131) im Bereich der Ausnehmung (132a) mittels einer selekt iven Ionenim- plantation mit einer solchen Implantationsenergie erfolgt, daß sich die Dotierung auf dem ganzen Querschnitt der dritten Polysiliziumschicht (131) bis zur Grenzfläche gegenüber der isolierenden Schicht (151) erstreckt.

19. Verfahren nach einem der Ansprüche 16 bis 18, d a - d u r c h g e k e n n z e i c h n e t , daß eine unterhalb des Gebiets (3) liegende Zone (93) der Halbleiterschicht (2) stärker dotiert wird als die übrigen Teile derselben.

20. Verfahren nach einem der Ansprüche 16 bis 19, d a d u r c h g e k e n n z e i c h n e t , daß die Halbleiterschicht (2) epitaktisch auf dem Halbleiterkörper (1) abgeschieden wird.

21. Verfahren nach einem der Ansprüche 16 bis 19 d a - d u r c h g e k e n n z e i c h n e t , daß die Halbleiterschicht (2) in den Halbleiterkörper (1) ein- diffundiert wird.

FIG1

FIG2

FIG3

0024732

FIG4

$V_D$

20

$\phi 1$

23

24

z

FIG5

$V_D$

25

20'

$\phi 1'$

23'

FS

24

z

FIG6

11    16    21

12

22

9  10  16'    2  1a

1

13

FIG7

I

29

26

27

28

25

20'    20

V

FIG 8

FIG 9

FIG 10

FIG 11

## FIG 12

## FIG 13

## FIG 14

FIG 15

FIG 16

FIG 17

## FIG 18

## FIG 19